# EUROPEAN PATENT APPLICATION

(11) **EP 4 418 194 A1**
(43) Date of publication of application: **21.08.2024**
(21) Application number: 23880013.0
(22) Date of filing: 06.09.2023
(51) Int. Cl.: G06Q 50/10, H01M 10/04, G05B 19/05, G01R 31/385, G01R 31/392, G01R 31/396

(54) **MONITORING SYSTEM AND OPERATING METHOD THEREOF**

(30) Priority: 19.10.2022 KR 20220135173; 28.08.2023 KR 20230112601
(71) Applicant: LG Energy Solution, Ltd., Seoul 07335 (KR)
(72) Inventor: SIM, Min Kyu, Daejeon 34122 (KR); KIM, June Hee, Daejeon 34122 (KR); PARK, Jong Seok, Daejeon 34122 (KR); HAN, Ki Deok, Daejeon 34122 (KR); PARK, Su Wan, Daejeon 34122 (KR); JEON, Gi Yeong, Daejeon 34122 (KR); LEE, Jae Hwan, Daejeon 34122 (KR)
(74) Representative: BCKIP Part mbB
(86) International application number: PCT/KR2023/013362
(87) International publication number: WO 2024/085433

(57) **Abstract**

A monitoring system according to an embodiment of the present disclosure includes a programmable logic controller (PLC) configured to receive specification information of at least one electrode from a first sensor, receive coordinates of a position of the at least one electrode from a second sensor, and generate identification information of each of the at least one electrode on the basis of the specification information and the coordinates of the position, an inspection device configured to inspect the at least one electrode to generate inspection information, and a controller configured to manage the identification information and the inspection information of the at least one electrode by matching the identification information and the inspection information.

## Description

### [Technical Field]

Embodiments set forth herein relate to a monitoring system and an operating method thereof.

This application claims the benefit of priority based on Korean Patent Application No. 1 0-2022-0135173, filed on October 19, 2022 and Korean Patent Application No. 10-2023-0112601, filed on August 28, 2023, and the entire contents of the Korean patent applications are incorporated herein by reference.

### [Background Art]

An electric vehicle is supplied with electric power from the outside to charge a battery cell and generates power by driving a motor with voltage charged in the battery cell. The battery cell of the electric vehicle is manufactured by accommodating an electrode assembly in a battery case and injecting an electrolyte into the battery case.

Battery cells are classified into cylindrical batteries, prismatic batteries, and pouch type batteries according to the type of battery case. A cylindrical battery cell include an electrode assembly, a battery case of a cylindrical metal can that accommodates the electrode assembly and an electrolyte, and a cap assembly assembled with an upper part of the cylindrical metal can.

During the manufacture of negative electrodes of battery cells, unique physical identifiers (IDs) are marked on the foils of the negative electrodes to ensure the traceability of each of the negative electrodes on the basis of the marked physical IDs. However, because the foils of positive electrodes of the battery cells are formed of aluminum and fire, soot, or dust may occur during marking of physical IDs, physical IDs cannot be assigned, thus making it impossible to secure the traceability of each of the positive electrodes.

### [Disclosure]

### [Technical Problem]

Embodiments set forth herein are directed to providing a monitoring system for securing the traceability of data of positive electrodes by assigning virtual identifiers (IDs) on the basis of specification information of the positive electrodes, and an operating method thereof.

Technical aspects of the embodiments set forth herein are not limited thereto, and other technical aspects that are not described herein will be clearly understood by those of ordinary skill in the art from the following description.

### [Technical Solution]

A monitoring system according to an embodiment of the present disclosure includes a programmable logic controller (PLC) configured to receive specification information of at least one electrode from a first sensor, receive coordinates of a position of the at least one electrode from a second sensor, and generate identification information of each of the at least one electrode on the basis of the specification information and the coordinates of the position, an inspection device configured to inspect the at least one electrode to generate inspection information, and a controller configured to manage the identification information and the inspection information of the at least one electrode by matching the identification information and the inspection information.

In an embodiment, the PLC may receive a count value of the number of the at least one electrode according to a length of a tab of the at least one electrode from the first sensor, and the count value of the number of the at least one electrode may include a binary coded decimal (BCD) code.

In an embodiment, the PLC may receive roll map coordinates of the at least one electrode from an encoder installed in a rewinder included in a notching device configured to notch the at least one electrode.

In an embodiment, the PLC may generate an identifier (ID) of each of the at least one electrode on the basis of the specification information of the tab of the at least one electrode and the roll map coordinates.

In an embodiment, the inspection device may receive the specification information of the at least one electrode from the first sensor, and add the specification information to the inspection information of the at least one electrode.

In an embodiment, the controller may manage the ID of the at least one electrode and the inspection information of the at least one electrode by matching the ID and the inspection information.

In an embodiment, the controller may generate integrated inspection information of the at least one electrode by matching the ID of the at least one electrode and the inspection information of the at least one electrode, and transmit the integrated inspection information to a server.

An operating method of a monitoring system according to an embodiment of the present disclosure includes receiving specification information of at least one electrode from a first sensor, receiving coordinates of a position of the at least one electrode from a second sensor, generating identification information of each of the at least one electrode on the basis of the specification information and the coordinates of the position, generating inspection information by inspecting the at least one electrode, and managing the identification information and the inspection information of the at least one electrode by matching the identification information and the inspection information.

In an embodiment, the receiving of the specification information of the at least one electrode from the first sensor may include receiving a count value of the number of the at least one electrode according to a length of a tab of the at least one electrode from the first sensor, and the count value of the number of the at least one electrode may include a binary coded decimal (BCD) code.

In an embodiment, the receiving of the coordinates of the position of the at least one electrode from the second sensor may include receiving roll map coordinates of the at least one electrode from an encoder installed in a rewinder included in a notching device configured to notch the at least one electrode.

In an embodiment, the generating of the identification information of each of the at least one electrode on the basis of the specification information and the coordinates of the position may include generating an identifier (ID) of each of the at least one electrode on the basis of the specification information of the tab of the at least one electrode and the roll map coordinates.

In an embodiment, the generating of the inspection information by inspecting the at least one electrode may include receiving the specification information of the at least one electrode from the first sensor, and adding the specification information to the inspection information of the at least one electrode.

In an embodiment, the managing of the identification information and the inspection information of the at least one electrode by matching the identification information and the inspection information may include managing the ID of the at least one electrode and the inspection information of the at least one electrode by matching the ID and the inspection information.

In an embodiment, the managing of the identification information and the inspection information of the at least one electrode by matching the identification information and the inspection information may include generating integrated inspection information of the at least one electrode by matching the ID of the at least one electrode and the inspection information of the at least one electrode, and transmitting the integrated inspection information to a server.

### [Advantageous Effects]

According to a monitoring system and an operating method thereof according to an embodiment of the present disclosure, the traceability of data of positive electrodes can be secured by assigning virtual identifiers (IDs) on the basis of specification information of the positive electrodes.

### [Brief Description of the Drawings]

FIG. 1 is a diagram for describing an overview of a battery process system according to an embodiment of the present disclosure.
FIG. 2 is a block diagram illustrating a configuration of a monitoring system according to an embodiment of the present disclosure.
FIG. 3 is a diagram for describing a notching process according to an embodiment of the present disclosure.
FIG. 4 is a diagram illustrating roll map coordinates according to an embodiment of the present disclosure.
FIG. 5 is a diagram illustrating integrated inspection data according to an embodiment of the present disclosure.
FIG. 6 is a flowchart of an operating method of a monitoring system according to an embodiment of the present disclosure.
FIG. 7 is a block diagram illustrating a hardware configuration of a computing system for implementing a monitoring system according to an embodiment of the present disclosure.

### [Best Mode]

A monitoring system according to an embodiment of the present disclosure includes a programmable logic controller (PLC) configured to receive specification information of at least one electrode from a first sensor, receive coordinates of a position of the at least one electrode from a second sensor, and generate identification information of each of the at least one electrode on the basis of the specification information and the coordinates of the position, an inspection device configured to inspect the at least one electrode to generate inspection information, and a controller configured to manage the identification information and the inspection information of the at least one electrode by matching the identification information and the inspection information.

An operating method of a monitoring system according to an embodiment of the present disclosure includes receiving specification information of at least one electrode from a first sensor, receiving coordinates of a position of the at least one electrode from a second sensor, generating identification information of each of the at least one electrode on the basis of the specification information and the coordinates of the position, generating inspection information by inspecting the at least one electrode, and managing the identification information and the inspection information of the at least one electrode by matching the identification information and the inspection information.

### [Embodiments of the Present Invention]

Hereinafter, embodiments set forth herein will be described in detail with reference to exemplary drawings. It should be noted that the same reference numerals are assigned to the same components even in different drawings when reference numerals are assigned to components in each drawing. A description of well-known constructions or functions will not be described in detail when it is determined that the description would obscure the understanding of the embodiments of the present disclosure set forth herein in describing the embodiments.

Terms such as first, second, A, B, (a), and (b) may be used to describe components of the embodiments of the present disclosure. Such a term is only for distinguishing one component from another, and the essence of the component, an order or a sequence is not limited by the term. Unless otherwise defined, all terms used here, including technical or scientific terms, have the same meaning as those generally understood by those with ordinary knowledge in the technical field to which the embodiments disclosed herein belong. Terms such as those defined in commonly used dictionaries should be interpreted as having a meaning consistent with the contextual meaning of the relevant technology and should not be interpreted as ideal or excessively formal unless explicitly defined herein.

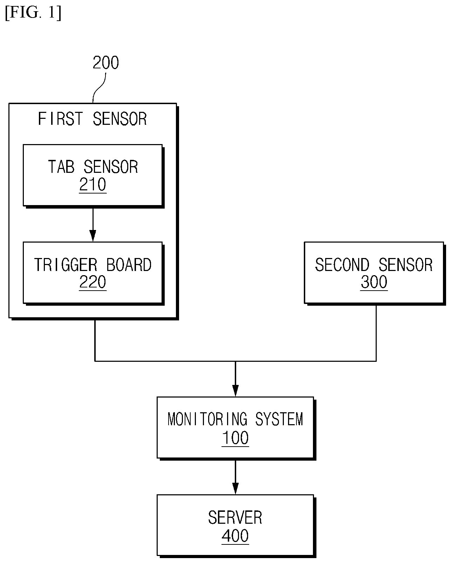

FIG. 1 is a diagram for describing an overview of a battery process system according to an embodiment of the present disclosure.

According to various embodiments, a battery may include a battery cell that is a basic unit of a battery that can be used by charging/discharging electrical energy. The battery cell may be a lithium-ion (Li-ion) battery, a lithium-ion polymer (Li-ion polymer) battery, a nickel cadmium (Ni-Cd) battery, a nickel hydrogen (Ni-MH) battery or the like but is not limited thereto. The battery cell may supply power to a target device (not shown). To this end, the battery cell may be electrically connected to the target device. Here, the target device may include an electrical, electronic, or mechanical device that is operated by supplying power thereto from a battery pack (not shown) including a plurality of battery cells. For example, the target device may be, but is not limited to, a small-sized product, such as a digital camera, a portable-digital versatile disc (P-DVD), an MP3-Plyaer (MP3P), a cellular phone, a personal digital assistant (PDA), a portable game device, a power tool, and an E-bike, a large-sized product that requires high power, such as an electric car or a hybrid car, or a power storage device or a backup power storage device that stores surplus generated power or renewable energy.

The battery cell may include an electrode assembly, a battery case accommodating the electrode assembly therein, and an electrolyte injected into the battery case to activate the electrode assembly. The electrode assembly is formed by interposing a separator between a positive electrode plate formed by coating a positive current collector with a positive active material and a negative electrode plate formed by coating a negative current collector with a negative active material, and may be manufactured as a jelly roll type, a stack type, or the like according to the type of battery case and accommodated in the battery case. The battery case serves as an exterior for maintaining the shape of a battery and protecting the battery from external impacts, and the battery cell may be classified as a cylindrical, prismatic, or pouch type battery according to the type of the battery case.

According to an embodiment, the battery cell may be manufactured through a series of manufacturing processes, including an electrode manufacturing process, an assembly process, and a formation process. Here, the assembly process may include assembling a positive plate and a negative plate, which are formed by the electrode manufacturing process, and injecting an electrolyte, and further include notching, winding, assembling, and packaging.

In the assembly process, notching may be defined as cutting the positive plate and the negative plate according to the shape of the battery to manufacture a positive tab and a negative tab. After the completion of the electrode manufacturing process, non-coated portions of the positive plate and the negative plate each having a roll shape are cut by notching, and the positive plate and the negative plate each having the roll shape are notched according to various battery shapes.

Hereinafter, a case in which a battery process system is applied to the assembly process will be described as an example. For example, the battery process system may be used for notching in the assembly process system but embodiments are not limited thereto.

Referring to FIG. 1, the battery process system may include a monitoring system 100, a first sensor 200, a second sensor 300, and a server 400.

The monitoring system 100 may collect and manage data of electrodes generated in a battery manufacturing process in real time. For example, the monitoring system 100 may collect and analyze data or graph data generated in the battery process system, such as the progress of a process in the battery process system, whether an alarm has been generated, temperature, pressure, quantity, etc.

The monitoring system 100 may track each of electrodes to manage data of each of at least one electrode generated during the manufacture of an electrode assembly. First, in the case of a negative electrode, a physical identifier (ID) may be assigned in the form of barcode to a tab of the negative electrode from a laser device during notching in the battery assembly process. That is, a unique physical ID may be marked in the form of barcode on a tab of a negative electrode during notching, and identified by a bar code reader (BCR) device. Therefore, each of a plurality of negative electrodes may be matched with one of physical IDs, so that the traceability of data thereof may be secured by an upper system on the basis of the physical IDs. In the case of negative electrodes, the monitoring system 100 may manage each of the negative electrodes on the basis of the physical IDs marked on the tabs of the negative electrodes.

Meanwhile, in the case of positive electrodes, the monitoring system 100 may receive data of each of at least one positive electrode from the first sensor 200 and the second sensor 300 of the battery process system, and track and manage the at least one positive electrodes on the basis of the received data.

Specifically, the monitoring system 100 may receive specification information of at least one positive electrode from the first sensor 200 capable of identifying specification information of positive electrodes.

The first sensor 200 may include a tab sensor 210 and a trigger board 220. First, the tab sensor 210 may identify specification information of tabs of a positive electrode. Specifically, the tab sensor 210 may identify the length, i.e., a pitch, of each of the tabs of the positive electrode. The tab sensor 210 may transmit information about the detected length of each of the tabs of the positive electrode to the trigger board 220. The trigger board 220 may generate count information of the tabs of the positive electrode on the basis of the information about the length of each of the tabs of the positive electrode received from the tab sensor 210. That is, the trigger board 220 may increase a count value for the length of each of the tabs of the positive electrode. The trigger board 220 may increase a binary coded decimal (BCD) code by 1 whenever the count value for the length of each of the tabs of the positive electrode increases. The trigger board 220 may convert the count value generated for the length of each of the tabs of the positive electrode into a BCD code and transmit the BCD code to the monitoring system 100.

In addition, the monitoring system 100 may receive the coordinates of a position of at least one electrode from the second sensor 300 capable of identifying the coordinates of positions of positive electrodes.

The second sensor 300 may calculate the coordinates of a position of each of at least one electrode. The second sensor 300 may include an encoder installed in a rewinder RW of a notching device for notching at least one electrode. The second sensor 300 may calculate the coordinates of a position of an electrode on the basis of a linear moving distance of the electrode.

The monitoring system 100 may generate virtual identification information of each of at least one positive electrode on the basis of specification information of and coordinates of positions of positive electrodes. That is, the monitoring system 100 may track and manage data of the positive electrodes on the basis of the virtual identification information generated based on the specification information of and the coordinates of the positions of the positive electrodes.

In addition, the monitoring system 100 may transmit the generated virtual identification information of the positive electrodes and the data of the positive electrodes tracked on the basis of the virtual identification information of the positive electrodes to the server 400 that is an upper system. Here, the server 400 may manage the data of the positive electrodes transmitted from the monitoring system 100 by integrating information about the quality of each of the positive electrodes, information about whether there is a defect in each of the positive electrodes, and inspection information of each of the positive electrodes. The server 400 may include, for example, cloud computing technology.

Collecting and managing data of electrodes by generating virtual identification information of the electrodes by the monitoring system 100 will be described below. Hereinafter, electrodes will be described, for example, with respect to positive electrodes but embodiments are not limited thereto.

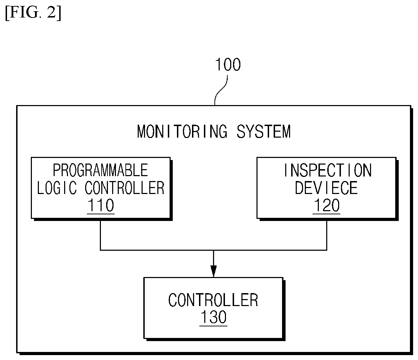

FIG. 2 is a block diagram illustrating a configuration of a monitoring system 100 according to an embodiment of the present disclosure.

Referring to FIG. 2, the monitoring system 100 may include a programmable logic controller (PLC) 110, an inspection device 120, and a controller 130.

The PLC 110 may be defined as a control device used for maintenance, management, automatic control, and monitoring of a battery process system. For example, the PLC 110 may manage driving of an electrode notching device.

A plurality of control signals may be input to the PLC 110. The PLC 110 may process the plurality of control signals simultaneously or sequentially using software stored therein. The software of the PLC 110 may be stored in a volatile or nonvolatile memory. The software of the PLC 110 may process a control signal input to the PLC 110 in real time.

The PLC 110 may receive specification information of at least one electrode from the first sensor 200. Specifically, the PLC 110 may receive length information of a tab of at least one electrode, i.e., pitch information, from the first sensor 200.

The PLC 110 may generate count information of at least one electrode on the basis of length information of the at least one electrode received from the first sensor 200. Specifically, the PLC 110 may receive a count value of the number of the at least one electrode according to the length information of the at least one electrode received from the first sensor 200. Here, the count value of the number of the at least one electrode may include a BCD code.

The PLC 110 may receive the coordinates of a position of at least one electrode from the second sensor 300. Here, the second sensor 300 may include an encoder installed in a notching device for notching at least one electrode.

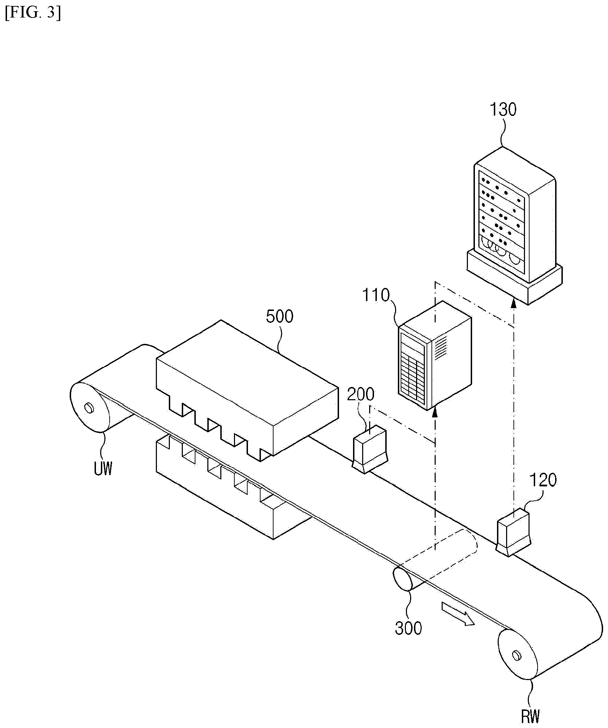

FIG. 3 is a diagram for describing a notching process according to an embodiment of the present disclosure.

Referring to FIG. 3, a notching device 500 may process an electrode by cutting the electrode. The electrode includes a coated part coated with an electrode active material and an uncoated part that is not coated with the electrode active material. The notching device 500 may cut the uncoated part of the electrode to form a tab of the electrode.

The first sensor 200 may generate specification information including the length of the tab of the electrode formed by the notching device 500 and a count value of the number of the at least one electrode according to the length of the tab.

The second sensor 300 may generate coordinates of a position of at least one electrode. The second sensor 300 may include an encoder installed in a rewinder RW of the notching device 500 for notching at least one electrode. According to an embodiment, the encoder may be installed outside an unwinder UW of or the rewinder RW of the notching device 500. Alternatively, according to an embodiment, the encoder may be included in the unwinder UW or the rewinder RW of the notching device 500.

The second sensor 300 may calculate the coordinates of a position of each of at least one electrode on the basis of the number of pulses input from the encoder. Specifically, the encoder may be installed in a driving motor for driving the rewinder RW of the notching device 500, and calculate a moving distance of an electrode according to the number of revolutions of the driving motor. The encoder may generate a pulse signal by capturing light passing through a plurality of slits in a rotating plate of the driving motor. The second sensor 300 may calculate the number of rotations of the driving motor on the basis of the pulse signal input from the encoder, and calculate a linear moving distance of the electrode between the unwinder UW and the rewinder RW on the basis of the number of rotations of the driving motor. The second sensor 300 may calculate the coordinates of a position of the electrode on the basis of the linear moving distance of the electrode.

The PLC 110 may receive the coordinates of a position of at least one electrode from the second sensor 300 that includes the encoder. In an embodiment, the PLC 110 may receive roll map coordinates of the at least one electrode from the second sensor 300 that includes the encoder.

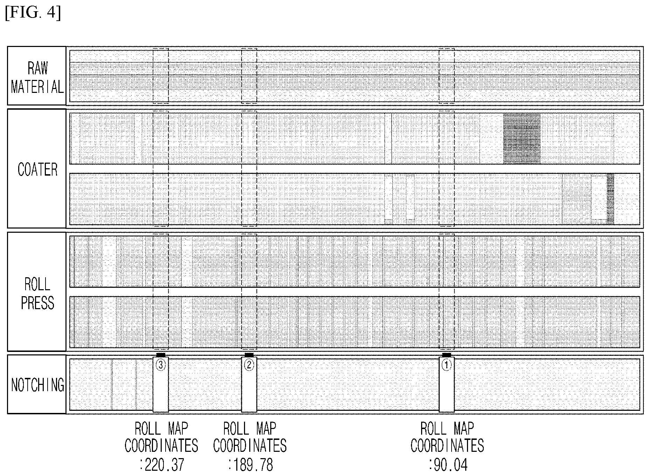

FIG. 4 is a diagram illustrating roll map coordinates according to an embodiment of the present disclosure.

Referring to FIG. 4, the PLC 110 may receive the coordinates of a roll map of at least one electrode from the second sensor 300 that includes an encoder. Here, the roll map simulates an electrode that is in a roll-to-roll state, in which data related to the quality of the electrode, whether there is a defect in the electrode, and the manufacture of the electrode is displayed on a bar of the roll map. When a defect occurs in a battery manufactured with electrodes manufactured in the electrode manufacturing process, manufacturing history data of the electrodes is required to identify a cause of the defect. In the roll map, electrode manufacturing history data in a series of electrode manufacturing processes, including an electrode coating process, a roll press process, a notching process, etc., may be recorded to specify the cause of the defect in relation to a relationship between subsequent processes.

For example, in the roll map, an actual electrode installed and moved in a roll-to-roll state between the unwinder UW and the rewinder RW of the notching device 500 in the electrode notching process is simulated and displayed on the roll map bar. The roll map may be displayed on a screen in synchronization with a moving path of the electrode between the unwinder UW and the rewinder RW of the notching device 500.

The second sensor 300 may generate the coordinates of a position of at least one notched electrode moved between the unwinder UW and the rewinder RW, i.e., roll map coordinates.

For example, the PLC 110 may receive `220.37' as roll map coordinates of an electrode ③ of FIG. 4 from the second sensor 300. For example, the PLC 110 may receive '189.78' as roll map coordinates of an electrode ② of FIG. 4 from the second sensor 300. For example, the PLC 110 may receive '90.04' as roll map coordinates of an electrode ① of FIG. 4 from the second sensor 300.

The PLC 110 may generate identification information of each of at least one electrode on the basis of specification information of each of the at least one electrode received from the first sensor 200 and the coordinates of a position of each of the at least one electrode received from the second sensor 300. Specifically, the PLC 110 may generate a virtual ID of each of the at least one electrode on the basis of specification information of a tab of at least one positive electrode received from the first sensor 200 and roll map coordinates of the at least one positive electrode received from the second sensor 300.

The inspection device 120 may generate inspection information by inspecting at least one electrode. Here, the inspection device 120 may include, for example, a vision inspection sensor. Here, the vision inspection sensor is capable of identifying the shape and size of an object to be inspected, characters, a pattern, etc. using an industrial camera similar to when viewed with human eyes to inspect physical defects, missing components, or quality of a product. The inspection device 120 may inspect the quality of at least one electrode using the vision inspection sensor to generate inspection information. Specifically, the inspection device 120 may obtain an image of an electrode captured by photographing the electrode, and analyze the image of the electrode to inspect whether there is a defect or the quality of the electrode. Here, the defect may include not only poor quality of the electrode but also various defects such as defects in alignment, size, etc.

The inspection device 120 may measure a pitch of a plurality of tabs formed by notching by the notching device 500.

The inspection device 120 may receive specification information of at least one electrode from the first sensor 200. The inspection device 120 may add the received specification information of the at least one electrode to the generated inspection information of the at least one electrode. The inspection device 120 may transmit a result of adding the specification information of the at least one electrode to the inspection information of the at least one electrode to the controller 130.

The controller 130 may receive specification information of each of at least one electrode and virtual identification information of the at least one electrode from the PLC 110. In addition, the controller 130 may receive specification information of the at least one electrode and inspection information of the at least one electrode from the inspection device 120. The controller 130 may manage the virtual identification information of the at least one electrode received from the PLC 110 and the inspection information of the at least one electrode received from the inspection device 120 by matching the virtual identification information and the inspection information. Specifically, the controller 130 may manage an ID of the at least one electrode and the inspection information of the at least one electrode by matching the ID and the inspection data.

The controller 130 may generate integrated inspection information of the at least one electrode by matching the ID of the at least one electrode with the inspection information of the at least one electrode.

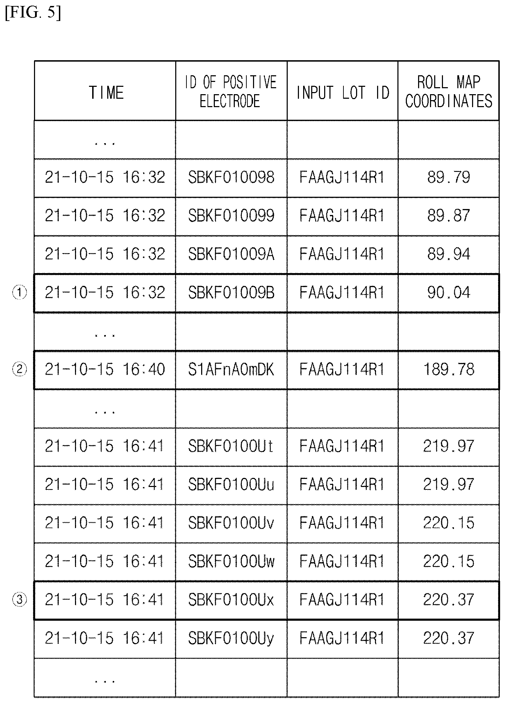

FIG. 5 is a diagram illustrating integrated inspection data according to an embodiment of the present disclosure.

Referring to FIG. 5, the controller 130 may generate integrated inspection data by integrating information about a notching time of each of at least one notched electrode, a virtual electrode ID, an ID of a lot input to generate electrodes, and roll map coordinate information. Here, the ID of the input Lot should be understood to mean a lot number of an electrode roll when installed in a roll-to-roll state between the unwinder UW and the rewinder RW.

The controller 130 may transmit the generated integrated inspection information to the server 400. Here, the server 400 may be, for example, a static process control (SPC) device. Here, SPC is a management method of efficiently performing a process in a statistical way to achieve quality or productivity required in the process. The server 400 may statistically manage the integrated inspection data of each of the at least one electrode, which is obtained through the controller 130, to check the quality of the at least one electrode and monitor a manufacturing status of the at least one electrode that may be identified on the basis of the coordinates of the position thereof.

As described above, according to a monitoring system of an embodiment of the present disclosure, the traceability of data of positive electrodes can be secured by assigning virtual IDs on the basis of specification information of the positive electrodes.

The monitoring system may assign virtual positive electrode IDs in the same manner as a negative electrode tracking system and transmit data to a higher system to secure the traceability of positive and negative electrodes and provide an analysis environment.

In addition, the monitoring system may integrate not only inspection data of positive electrodes but also all pieces of data, e.g., equipment data, about the positive electrodes generated and collected in a notching process to be managed by an upper system in an integrated manner.

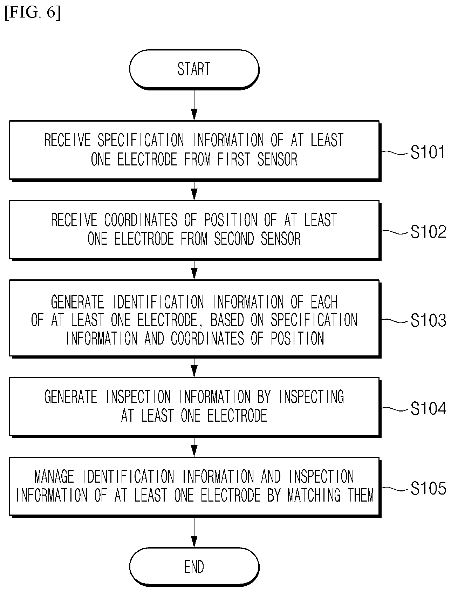

FIG. 6 is a flowchart of an operating method of a monitoring system according to an embodiment of the present disclosure.

An operating method of the monitoring system 100 will be described with reference to FIGS. 1 to 5 below.

The monitoring system 100 may be substantially the same as the monitoring system 100 described above with reference to FIGS. 1 to 4 and thus will be briefly described below to avoid redundant description.

Referring to FIG. 6, the operating method of the monitoring system 100 may include receiving specification information of at least one electrode from the first sensor 200 (S101), receiving the coordinates of a position of the at least one electrode from the second sensor 300 (S102), generating identification information of each of the at least one electrode on the basis of the specification information and the coordinates of the position (S103), generating inspection information by inspecting the at least one electrode (S104), and managing the identification information and the inspection information of the at least one electrode by matching the identification information and the inspection information (S105).

In operation S101, the PLC 110 may receive specification information of at least one electrode from the first sensor 200. The PLC 110 may be defined as a control device used for maintenance, management, automatic control, and monitoring of a battery process system. For example, the PLC 110 may manage driving of an electrode notching device.

In operation 101, a plurality of control signals may be input to the PLC 110. The PLC 110 may process the plurality of control signals using software installed therein simultaneously or sequentially. In operation S101, the software of the PLC 110 may be stored in a volatile or nonvolatile memory. The software of the PLC 110 may process a control signal input to the PLC 110 in real time.

In operation S101, the PLC 110 may receive specification information of at least one electrode from the first sensor 200. Specifically, the PLC 110 may receive information about the length of a tab of at least one electrode, i.e., pitch information, from the first sensor 200.

In operation S101, the PLC 110 may generate count information of at least one electrode on the basis of length information of the at least one electrode received from the first sensor 200. Specifically, in operation S101, the PLC 110 may receive a count value of the number of the at least one electrode according to the length information of the at least one electrode received from the first sensor 200. Here, the count value of the number of the at least one electrode may include a BCD code.

In operation S102, the PLC 110 may receive the coordinates of a position of the at least one electrode from the second sensor 300. Here, the second sensor 300 may include an encoder installed in a notching device for notching at least one electrode.

In operation S102, the second sensor 300 may generate the coordinates of the position of the at least one electrode. The second sensor 300 may include an encoder installed in a rewinder RW of the notching device 500 for notching at least one electrode.

In operation S102, the second sensor 300 may calculate the coordinates of the position of each of the at least one electrode on the basis of the number of pulses input from the encoder. The second sensor 300 may calculate the number of rotations of a driving motor on the basis of a pulse signal input from the encoder, and calculate a linear moving distance of an electrode between the unwinder UW and the rewinder RW on the basis of the number of rotations of the driving motor. The second sensor 300 may calculate the coordinates of the position of the electrode on the basis of the linear moving distance of the electrode.

In operation S102, the PLC 110 may receive the coordinates of the position of the at least one electrode from the second sensor 300 that includes the encoder. In an embodiment, the PLC 110 may receive the coordinates of at least one electrode on a roll map from the second sensor 300 that includes the encoder. Here, the roll map simulates an electrode that is in a roll-to-roll state, in which data related to the quality of the electrode, whether there is a defect in the electrode, and the manufacture of the electrode is displayed on a bar of the roll map in an electrode manufacturing process. A battery is manufactured with electrodes manufactured in the electrode manufacturing process. In this case, manufacturing history data of the electrodes is required to identify a cause of a defect occurring in the battery (when completed). In the roll map, electrode manufacturing history data in a series of electrode manufacturing processes, including an electrode coating process, a roll press process, a notching process, etc., may be recorded on the basis of roll map coordinates to specify the cause of the defect in relation to a relationship between subsequent processes.

In operation S102, the second sensor 300 may generate the coordinates of a position of at least one notched electrode moved between the unwinder UW and the rewinder RW, i.e., roll map coordinates.

In operation S103, the PLC 110 may generate identification information of each of the at least one electrode on the basis of the specification information of each of the at least one electrode received from the first sensor 200 and the coordinates of the position of each of the at least one electrode received from the second sensor 300. Specifically, in operation S103, the PLC 110 may generate a virtual ID of each of the at least one electrode on the basis of specification information of a tab of the at least one positive electrode received from the first sensor 200 and roll map coordinates of at least one positive electrode received from the second sensor 300.

In operation S104, the inspection device 120 may generate inspection information by inspecting the at least one electrode. Here, the inspection device 120 may include, for example, a vision inspection sensor. In operation S104, the inspection device 120 may inspect the quality of the at least one electrode using the vision inspection sensor to generate inspection information. Specifically, the inspection device 120 may obtain an image of an electrode captured by photographing the electrode, and analyze the image of the electrode to inspect whether there is a defect or the quality of the electrode.

In operation S104, the inspection device 120 may measure a pitch of a plurality of tabs formed by notching by the notching device 500.

In operation S104, the inspection device 120 may receive the specification information of the at least one electrode from the first sensor 200. In operation S104, the inspection device 120 may add the received specification information of the at least one electrode to the generated inspection information of the at least one electrode. In operation S104, the inspection device 120 may transmit a result of adding the specification information of the at least one electrode to the inspection information of the at least one electrode to the controller 130.

In operation S105, the controller 130 may receive the specification information of each of the at least one electrode and virtual identification information of the at least one electrode from the PLC 110.

In operation S105, the controller 130 may receive the specification information of the at least one electrode and the inspection information of the at least one electrode from the inspection device 120.

In operation S105, the controller 130 may manage the virtual identification information of the at least one electrode received from the PLC 110 and the inspection information of the at least one electrode received from the inspection device 120 by matching the virtual identification information and the inspection information. Specifically, in operation S105, the controller 130 may manage an ID of the at least one electrode and the inspection information of the at least one electrode by matching the ID and the inspection information.

In operation S105, the controller 130 may generate integrated inspection information of the at least one electrode by matching the ID of the at least one electrode with the inspection information of the at least one electrode. In operation S105, the controller 130 may generate integrated inspection data by integrating information about a notching time of each of at least one notched electrode, a virtual electrode ID, an ID of a Lot input to generate electrodes, and roll map coordinate information. Here, the ID of the input Lot should be understood to mean a lot number of an electrode roll when installed in a roll-to-roll state between the unwinder UW and the rewinder RW.

In operation S105, the controller 130 may transmit the generated integrated inspection information to the server 400. Here, the server 400 may be, for example, a static process control (SPC) device. Here, SPC is a management method of efficiently performing a process in a statistical way to achieve quality or productivity required in the process.

In operation S105, the server 400 may statistically manage the integrated inspection data of each of the at least one electrode, which is obtained through the controller 130, to check the quality of the at least one electrode and monitor a manufacturing status of the at least one electrode that may be identified on the basis of the coordinates of the position thereof.

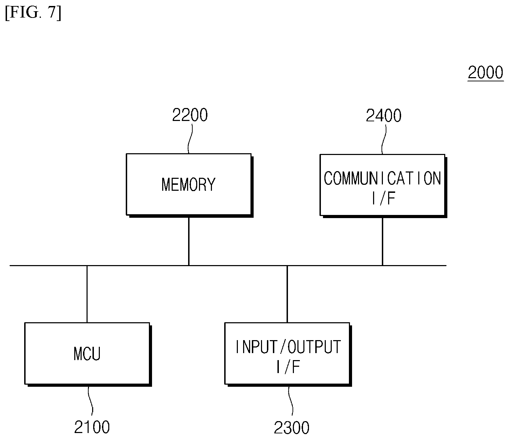

FIG. 7 is a block diagram illustrating a hardware configuration of a computing system for implementing a monitoring system according to an embodiment of the present disclosure.

Referring to FIG. 7, a computing system 1000 according to an embodiment of the present disclosure may include a micro-controller unit (MCU) 2100, a memory 2200, an input/output interface (I/F) 2300, and a communication I/F 2400.

The MCU 2100 may be a processor that executes various programs (for example, a program for identifying specification information of a positive electrode) stored in the memory 2200 and performs the above-described functions of the monitoring system 100 shown in FIG. 1. Various types of data may be processed by these programs.

The memory 2200 may store various programs related to an operation. In addition, the memory 2200 may store operation data.

A plurality of memories 2200 may be provided as necessary. The memory 2200 may be a volatile memory or a nonvolatile memory.

A random access memory (RAM), a dynamic RAM (DRAM), a static RAM (SRAM), or the like may be used as the memory 2200 when the memory 2200 is the volatile memory. A read-only memory (ROM), a programmable ROM (PROM), an electrically alterable ROM (EAROM), an erasable programmable ROM (EPROM), an electrically erasable and programmable ROM (EEPROM), a flash memory, or the like may be used as the memory 2200 when the memory 2200 is the nonvolatile memory. The above examples of the memory 2200 are only examples and embodiments are not limited thereto.

The input/output I/F 2300 may provide an interface for connecting an input device (not shown), such as a keyboard, a mouse or a touch panel, an output device, such as a display (not shown), and the MCU 2100 to transmit and receive data therebetween.

The communication I/F 2400 is configured to transmit and receive various types of data with a server, and may include various types of devices capable of supporting wired or wireless communication. For example, a program for measuring a resistance and diagnosing abnormality, various types of data, etc. may be transmitted to or received from a separate external server through the communication I/F 2400.

As described above, a computer program according to an embodiment of the present disclosure may be recorded on the memory 2200 and executed by the MCU 2100, and be implemented, for example, as a module for performing the functions of the monitoring system 100 described above with reference to FIGS. 1 and 2.

The above description merely provides examples of the technical idea of the present disclosure, and various changes and modification may be made by those of ordinary skill in the art to which the present disclosure pertain without departing from essential characteristics of the present disclosure.

Therefore, the embodiments set forth herein are not intended to limit the technical idea of the present disclosure but are provided to describe the technical idea, and thus the scope of the technical idea of the present disclosure is not limited by the embodiments. The scope of protection for the present disclosure should be interpreted based on the following claims, and it should be understood that all technical ideas equivalent thereto fall within the scope of the present disclosure.

### (Reference Numerals)

100: monitoring system
110: programmable logic controller
120: inspection device
130: controller
200: first sensor
210: tab sensor
220: trigger board
300: second sensor
400: server
500: notching device
200: computing system
2100: MCU
2200: memory
2300: input/output I/F
2400: communication I/F

## Claims

1. A monitoring system comprising:
a programmable logic controller (PLC) configured to receive specification information of at least one electrode from a first sensor, receive coordinates of a position of the at least one electrode from a second sensor, and generate identification information of each of the at least one electrode on the basis of the specification information and the coordinates of the position;
an inspection device configured to inspect the at least one electrode to generate inspection information; and
a controller configured to manage the identification information and the inspection information of the at least one electrode by matching the identification information and the inspection information.

2. The monitoring system of claim 1, wherein the PLC receives a count value of the number of the at least one electrode according to a length of a tab of the at least one electrode from the first sensor, wherein the count value of the number of the at least one electrode comprises a binary coded decimal (BCD) code.

3. The monitoring system of claim 2, wherein the PLC receives roll map coordinates of the at least one electrode from an encoder installed in a rewinder included in a notching device configured to notch the at least one electrode.

4. The monitoring system of claim 3, wherein the PLC generates an identifier (ID) of each of the at least one electrode on the basis of the specification information of the tab of the at least one electrode and the roll map coordinates.

5. The monitoring system of claim 4, wherein the inspection device receives the specification information of the at least one electrode from the first sensor, and adds the specification information to the inspection information of the at least one electrode.

6. The monitoring system of claim 5, wherein the controller manages the ID of the at least one electrode and the inspection information of the at least one electrode by matching the ID and the inspection information.

7. The monitoring system of claim 6, wherein the controller generates integrated inspection information of the at least one electrode by matching the ID of the at least one electrode and the inspection information of the at least one electrode, and transmits the integrated inspection information to a server.

8. An operating method of a monitoring system, comprising:
receiving specification information of at least one electrode from a first sensor;
receiving coordinates of a position of the at least one electrode from a second sensor;
generating identification information of each of the at least one electrode on the basis of the specification information and the coordinates of the position;
generating inspection information by inspecting the at least one electrode; and
managing the identification information and the inspection information of the at least one electrode by matching the identification information and the inspection information.

9. The operating method of claim 8, wherein the receiving of the specification information of the at least one electrode from the first sensor comprises receiving a count value of the number of the at least one electrode according to a length of a tab of the at least one electrode from the first sensor, wherein the count value of the number of the at least one electrode comprises a binary coded decimal (BCD) code.

10. The operating method of claim 9, wherein the receiving of the coordinates of the position of the at least one electrode from the second sensor comprises receiving roll map coordinates of the at least one electrode from an encoder installed in a rewinder included in a notching device configured to notch the at least one electrode.

11. The operating method of claim 10, wherein the generating of the identification information of each of the at least one electrode on the basis of the specification information and the coordinates of the position comprises generating an identifier (ID) of each of the at least one electrode on the basis of the specification information of the tab of the at least one electrode and the roll map coordinates.

12. The operating method of claim 11, wherein the generating of the inspection information by inspecting the at least one electrode comprises receiving the specification information of the at least one electrode from the first sensor, and adding the specification information to the inspection information of the at least one electrode.

13. The operating method of claim 12, wherein the managing of the identification information and the inspection information of the at least one electrode by matching the identification information and the inspection information comprises managing the ID of the at least one electrode and the inspection information of the at least one electrode by matching the ID and the inspection information.

14. The operating method of claim 13, wherein the managing of the identification information and the inspection information of the at least one electrode by matching the identification information and the inspection information comprises generating integrated inspection information of the at least one electrode by matching the ID of the at least one electrode and the inspection information of the at least one electrode, and transmitting the integrated inspection information to a server.

15. An electrode with an identifier (ID) generated by the monitoring system of claim 1 or the operating method of the monitoring system of claim 11.
